# EUROPÄISCHE PATENTSCHRIFT

(11) **EP 1 071 994 B1**
(45) Veröffentlichungstag und Bekanntmachung des Hinweises auf die Patenterteilung: **30.10.2002**
(21) Anmeldenummer: 99927689.2
(22) Anmeldetag: 16.04.1999
(51) Int. Cl.: G06F 11/20

(54) **SPEICHERANORDNUNG MIT REDUNDANTEN SPEICHERZELLEN UND VERFAHREN ZUM ZUGRIFF AUF REDUNDANTE SPEICHERZELLEN**
STORAGE DEVICE WITH REDUNDANT STORAGE CELLS AND METHOD FOR ACCESSING REDUNDANT STORAGE CELLS
DISPOSITIF MEMOIRE AVEC CELLULES MEMOIRE REDONDANTES ET PROCEDE D'ACCES AUXDITES CELLULES

(30) Priorität: 17.04.1998 DE 19817159
(43) Veröffentlichungstag der Anmeldung: 31.01.2001
(73) Patentinhaber: Infineon Technologies AG, 81669 München (DE)
(72) Erfinder: MENKE, Manfred, D-80799 München (DE); PLAN, Manfred, D-80798 München (DE)
(74) Vertreter: Fischer, Volker, Dipl.-Ing.
(86) Internationale Anmeldenummer: DE9901181
(87) Internationale Veröffentlichungsnummer: WO99054819

(56) Entgegenhaltungen:
- WO-A-93/21578
- DE-A- 3 827 174
- US-A- 4 051 354

## Beschreibung

Die Erfindung betrifft eine Speicheranordnung mit Speicherblökken mit über Adressen auswählbare redundanten Speicherzellen. Au ßerdem betrifft die Erfindung ein Verfahren zum Zugriff auf redundante Speicherzellen, die in Spalten und Zeilen in einer Speicheranordnung mit Speicherblöcken angeordnet sind.

Bei einem Speicher werden die zu speichernden Informationen in einzelnen Speicherzellen, die in Spalten und Zeilen zu einem Zellenfeld angeordnet sind, abgelegt. Jede Speicherzelle kann über Spalten- und Zeilenadressleitungen mit einer ihr zugeordneten Adresse zum Auslesen oder Schreiben der Zelle ausgewählt werden. Dazu sind die Adressleitungen mit Spalten- und Zeilendecodern verbunden. Diese decodieren die angelegte Adresse und aktivieren die zu der Adresse gehörende Spalten- und Zeilenadressleitungen.

Infolge der hohen Integrationsdichte und der immer kleiner werdenden Rastermaße steigt die Anfälligkeit für Defekte im Zellenfeld, wie beispielsweise schadhafte Speicherzellen oder gestörte Adressleitungen. Um bei einer gewissen Anzahl von Defekten eine bestimmte Mindestkapazität des Speichers zu gewährleisten, sind üblicherweise Vorrichtungen zum Ersatz der Defekte vorgesehen. In der Regel sind dies zusätzliche Speicherzellen, die mittels programmierbarer Codierungselemente anstelle der defekten Zellen eingesetzt werden.

Bei Speichern größerer Kapazität sind die Speicherzellen in mehrere Blöcke unterteilt. Wegen der matrixförmigen Anordnung der Speicherzellen müssen die zusätzlichen Zellen ebenfalls in Zeilen und Spalten angeordnet werden. Durch ein programmierbares Element werden in Abhangigkeit von der angelegten Adresse zu den zusätzlichen Zellen gehorende zusätzliche Leitungen selektiert. Die Programmierung dieser Elemente erfolgt über sogenannte Fusebänke, die lasertrennbare Verbindungen enthalten. Bei einem Test des Speichers werden die Adressen herausgefunden, die defekten Speicherzellen zugeordnet sind. Die Fusebänke werden dann so codiert, daß bei diesen Adressen auf die zusätzlichen (redundanten) Speicherzellen zugegriffen wird.

Aus der EP 0 612 074 A1 ist eine Spalten-Redundanz-Schaltungsanordnung für einen Speicher mit mehreren Speicherblöcken bekannt. Die programmierbaren Codierungselemente sind dort nicht den Blöcken fest zugeordnet. Vielmehr enthält jedes der Codierungselemente Adressdecodiermittel und ist somit einem beliebigen Speicherblock zuordenbar.

Untersuchungen haben gezeigt, daß Defekte oft gehäuft in einem Block auftreten. Andere Blöcke hingegen sind fehlerfrei. Die typischen Fehler sind Einzeldefekte, die entlang einer Spalten- und/oder Zeilenadresse auftreten, oder eine Anhäufung von benachbarten Einzeldefekten (Cluster). Wo diese Cluster auftreten, kann erst nach der Fertigung des Speichers durch einen Test festgestellt werden.

Um auch solche benachbarte Einzeldefekte durch redundante Leitungen beheben zu können, ist eine hohe Anzahl von redundanten Leitungen in jedem Block notwendig. Das führt jedoch zu einem Anwachsen der Chipfläche.

In der WO 93/21578 wird daher eine Speicheranordnung nach dem Obergriff des Anspruchs 1 sowie ein Verfahren zum Zugriff auf redundante Speicherzellen nach dem Oberbegriff des Anspruchs 4 vorgeschlagen, wobei die ursprünglich angelegte Adresse von einem Redundanzblockdecoder mit einer vorprogrammierten Adresse verglichen und bei Übereinstimmung ein entsprechender Redundanzwortleitungsdecoder bzw. Redundanzbitleitungsdecoder des entsprechenden Speicherblocks angesteuert wird, um auf eine durch den Redundanzwortleitungsdecoder und Redundanzbitleitungsdecoder adressierte redundante Speicherzelle zuzugreifen, wobei diese redundante Speicherzelle in einem anderen Speicherblock als die zu ersetzende ursprüngliche Speicherzelle angeordnet sein kann.

Der vorliegenden Erfindung liegt die Aufgabe zugrunde, einen Speicher mit Redundanzeinrichtung anzugeben, bei dem die Anzahl der Defekte, die mit Redundanzleitungen behoben werden können, erhöht sind, ohne daß dabei die Anzahl der Redundanzleitungen pro Block ansteigt. Diese Aufgabe wird durch eine Speicheranordnung mit den Merkmalen des Anspruchs 1 bzw. durch ein Verfahren zum Zugriff auf redundante Speicherzellen mit den Merkmalen des Anspruchs 4 gelöst.

Die Erfindung hat den Vorteil, daß zur Behebung eines Defektes in einem Speicherblock auch die Redundanzzellen eines benachbarten Speicherblocks verwendet werden können. Dadurch ist es möglich, in einem Speicherblock mehr Defekte zu beheben, als Redundanzleitungen in diesem Block vorhanden sind.

Weiterhin ist von Vorteil, daß zur Redundanz sowohl redundante Spalten- als auch redundante Zeilenleitungen benutzt werden können.

Das erfindungsgemäße Prinzip kann auf alle Speicherarchitekturen (DRAM, eDRAM core, SRAM, ROM, EEPROM), die pro Adresse ein Bit oder mehrere Bits an Informationen parallel schreiben oder lesen, angewendet werden.

Vorteilhafte Aus- und Weiterbildungen sind in Unteransprüchen gekennzeichnet. Die Erfindung wird nachfolgend anhand von Figuren näher erläutert. Es zeigen:

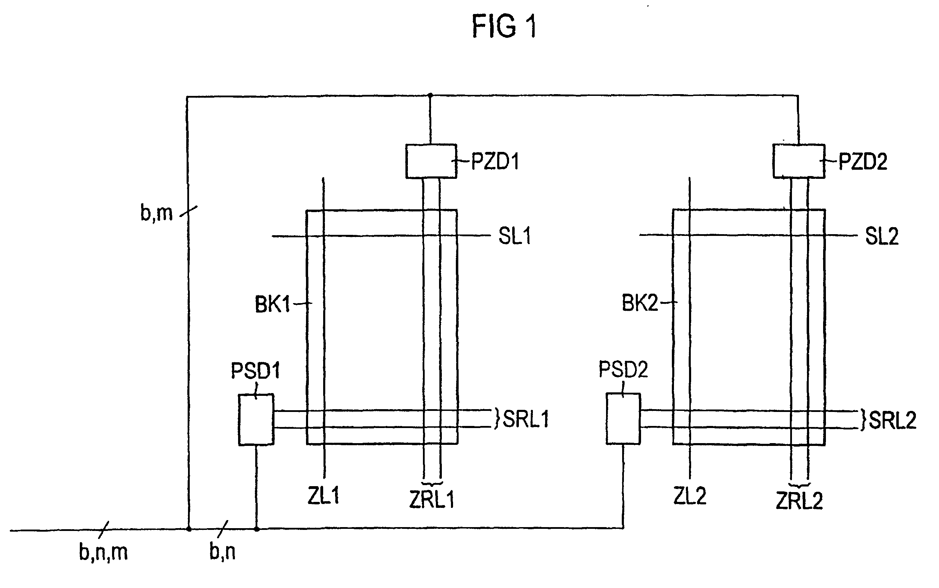

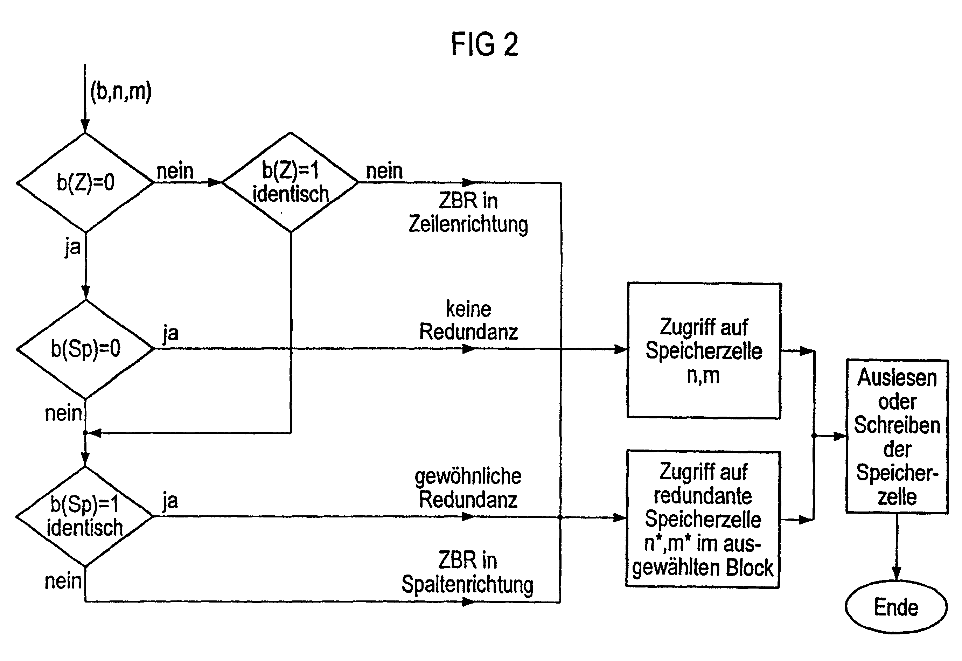

Figur 1 ein Prinzipschaltbild einer erfindungsgemäßen Speicheranordnung und Figur 2 ein Flußdiagramm zur Erläuterung des erfindungsgemäßen Verfahrens. Die Speicheranordnung gemäß Figur 1 weist zwei Speicherblöcke BK1 und BK2 auf. In jedem Speicherblock befinden sich Spalten- und Zeilenleitungen, über die auf eine Speicherzelle zugegriffen werden kann, in dem eine Auswahladresse an einen Spaltendecoder und Reihendecoder, die mit den Spalten- und Reihenleitungen verbunden sind, angelegt wird. In Figur 1 sind der Übersicht halber in jedem Block jeweils nur eine Spalten- und Zeilenleitung SL1, ZL1, SL2, ZL2 eingetragen. Ferner enthält die Speicheranordnung in diesem Ausfuhrungsbeispiel pro Block zwei Spaltenredundanzleitungen SRL1 im Block BK1 und SRL2 im Block BK2 und zwei Zeilenredundanzleitungen ZRL1 im Block BK1 und ZRL2 im Block BK2. Die Spaltenredundanzleitungen SRL1 sind mit einem programmierbaren Spaltendecoder PSD1, die Zeilenredundanzleitungen ZRL1 mit einem programmierbaren Zeilendecoder PZD1 verbunden. Entsprechend sind die Redundanzleitungen SRL2 und ZRL2 des Blocks BK2 mit einem programmierbaren Spaltendecoder PSD2 bzw. einem programmierbaren Zeilendecoder PZD2 verbunden. Die programmierbaren Decoder PSD1, PZD1, PSD2, PZD2 sind an eine Busleitung angeschlossen. An der Busleitung liegt eine Auswahladresse an, die aus einem Blockauswahlteil b, einem Spaltenauswahlteil n und einem Zeilenauswahlteil m zusammengesetzt ist. Sind wie in dem Ausführungsbeispiel nur zwei Blöcke vorhanden, so kann der Blockauswahlteil b beispielsweise aus-einem Bit bestehen, mit dem je nach Zustand der erste oder der zweite Block ausgewählt wird. Der Blockauswahlteil b und der Spaltenauswahlteil n liegen an den programmierbaren Spaltendecodern PSD1 und PSD2 an. Der Zeilenauswahlteil m und ebenfalls der Blockauswahlteil b der Auswahladresse sind über die Busleitung den programmierbaren Zeilendecodern PZD1 und PZD2 zugeführt.

Beim Zugriff auf eine defekte Speicherzelle, die im Block BK1 adressiert ist, kann beispielsweise über eine der Spaltenredundanzleitungen SRL1 auf eine redundante Speicherzelle im Block BK1 zugegriffen werden, um den Defekt zu beheben. Der Spaltendecoder PSD1 ist dann so programmiert, daß nicht auf die Spaltenleitung, die durch den Spaltenauswahlteil n bestimmt ist, zugegriffen wird, sondern auf eine der Spaltenredundanzleitung.

Erfindungsgemäß ist vorgesehen, daß mit der Auswahladresse für einen bestimmten Block ein anderer Block auswählbar ist. In dem Ausführungsbeispiel mit den beiden Blöcken BK1 und BK2 heißt das, daß der oben erwähnte Defekt im Block BK1 mit einer redundanten Speicherzelle im Block BK2 behoben werden kann. Dazu werden die an den programmierbaren Decodern PSD1, PSD2, PZD1 PZD2 anliegenden Auswahlteile der Auswahladresse jeweils mit den in den Decodern vorprogrammierten Adressen verglichen. Eine vorprogrammierte Adresse ist beispielsweise eine Auswahladresse einer defekten Speicherzelle eines bestimmten Blocks, die mit Redundanzspeicherzellen desselben Blocks nicht behoben werden kann, weil beispielsweise alle Redundanzleitungen dieses Blocks bereits für Reparaturzwecke vergeben sind. Wird bei einem Decoder eine Übereinstimmung des Teils der Auswahladresse mit der vorprogrammierten Adresse festgestellt, so wird der Block, der zu diesem Decoder gehört, aktiviert und der Zugriff auf die redundanten Speicherzellen dieses Blocks freigegeben. Alle übrigen Blöcke werden für Zugriffe gesperrt. Auf diese Weise können die Redundanzleitungen eines bestimmten Blocks für einen beliebigen anderen Block benutzt werden.

Stimmt beispielsweise in dem Ausführungsbeispiel mit den zwei Blöcken BK1 und BK2 der Blockauswahlteil b und der Zeilenauswahlteil m mit der vorprogrammierten Adresse des programmierbaren Reihendecoders PZD2 überein, so wird der zweite Block BK2 aktiviert. Dabei wird angenommen, daß die angelegte Auswahladresse zu einer defekten Speicherzelle des ersten Blocks BK1 gehört. Dem Zeilenauswahlteil m am Zeilendecoder PZD2 wird ein Redundanzzeilenadressteil m* zugeordnet, mit dem die Redundanzzeile, die für diese Auswahladresse vorgesehen ist, codiert ist. Der Spaltenauwahlteil n der Auswahladresse ist auch im Block BK2 gültig. Der Zugriff erfolgt also nicht auf die defekte Zelle im Block BK1, die mit n und m adressiert ist, sondern auf die redundante Speicherzelle im Block BK2, die mit n und m* adressiert ist. Es liegt also Zeilenredundanz vor. Die Zeilenredundanzleitungen RZL2 des Blocks BK2 könnten auch für weitere eventuell vorhandene Blöcke eingesetzt werden. Die Spaltenredundanzleitungen SRL2 des Blocks BK2 können aber in diesem Zeilenredundanzfall nur im selben Block BK2 benutzt werden, da ansonsten mehr als ein Block aktiviert werden müßte.

Es ist jedoch möglich, daß im erwähnten Beispiel auch dem Spaltenauswahlteil n der Auswahladresse ein Redundanzspalten-Adressteil n* zugeordnet wird. Dieser Fall der Spalten- und Zeilenredundanz wäre zum Beispiel denkbar, wenn ein eigener Redundanzblock vorgesehen ist, dessen Speicherzellen ausschließlich zur Reparatur von Speicherzellen der anderen Blöcke benutzt werden.

Stimmt beispielsweise der Blockauswahlteil b und der Spaltenauswahlteil e der Auswahladresse mit der vorprogrammierten Adresse des programmierbaren Spaltendecoders PSD2 überein, so wird der zweite Block BK2 aktiviert und über eine entsprechend zugeordnete Spaltenredundanzleitung SRL2 sowie den Zeilenauswahlteil m auf eine redundante Speicherzelle im Block BK2 zugegriffen. Dieser Spaltenredundanzfall verläuft analog zu dem Zeilenredundanzfall. Bei Spaltenredundanz- und Zeilenredundanz in einem Block werden alle redundanten Leitungen, d. h. die Zeilenredundanzleitungen und die Spaltenredundanzleitungen, einem anderen Block als Reparaturleitungen zur Verfügung gestellt.

Bei einer Speicherarchitektur mit p-Blöcken kann das beschriebene Redundanzprinzip auf diese p-Blöcke ausgedehnt werden. Unabhängig von der Realisierung läßt sich jede beliebige Speicherarchitektur auf solch eine Untermenge zurückführen. Liegen pro Block s Spaltenredundanzleitungen und z Zeilenredundanzleitungen vor, so können bis zu p·s Spalten und z Zeilen pro Block oder s Spalten und p·z Zeilen durch dieses Redundanzprinzip ausgetauscht werden. In der Regel werden zur Behebung von Defekten die vorhandenen Redundanzleitungen im Block selbst herangezogen. Reichen diese nicht aus, weil mehrere Defekte vorhanden sind, als mit diesen Leitungen repariert werden können, wird zusätzlich auf das erfindungsgemäß.e Redundanzprinzip zurückgegriffen.

Die vorhandenen p-Blöcke können in zwei Mengen unterteilt werden. Bei den Blöcken in der ersten Menge werden nur die Spaltenredundanzleitungen zur Behebung von Defekten in einem anderen Block, bei den Blöcken der zweiten Teilmenge nur die Reihenredundanzleitungen herangezogen. Es ist nicht moglich, beispielsweise die Spaltenredundanzleitungen eines ersten Blocks zur Reparatur von Defekten in einem zweiten Block und die Zeilenredundanzleitungen des ersten Blocks zur Reparatur von Defekten in einem dritten Block heranzuziehen. Spaltenredundanzleitungen und Zeilenredundanzleitungen können nur dann gemeinsam verwendet werden, wenn sowohl die Spaltenredundanzleitungen als auch die Zeilenredundanzleitungen beide für einen bestimmten Block herangezogen werden.

Das erfindungsgemäße Redundanzprinzip, das im folgenden als Zwischenblockredundanz (ZBR) bezeichnet ist, wird im anhand eines Fluß.diagramms gemäß Figur 2 erläutert. Startpunkt im Flußdiagramm ist die Auswahladresse, die sich wie bereits angegeben aus dem Block-, Spalten- und Zeilenauswahlteil b, n und m zusammensetzt. In einem ersten Schritt werden b und m mit der vorprogrammierten Adresse des Zeilendecoders eines Blocks BKi verglichen. Bei Übereinstimmung des Vergleichs wird dafür abkürzend b(Z)=1, wird bei dem Vergleich keine Übereinstimmung festgestellt, dafür abkürzend b(z)=0 geschrieben. Tritt keine Übereinstimmung auf, ist also b(Z)=0, so werden in einem weiteren Schritt b und n mit der vorprogrammierten Adresse des programmierbaren Spaltendecoders des Blocks Bki verglichen. Liegt keine Übereinstimmung vor, ist also b (Sp)=0, so ist für diese Auswahladresse keine Redundanz vorgesehen. Die Blockauswahl erfolgt über den Blockauswahlteil b der angelegten Auswahladresse. Auf die Speicherzelle wird entsprechend des Spaltenauswahlteils n und des Zeilenauswahlteils m zugegriffen. Die Speicherzelle wird ausgelesen oder beschrieben.

Wird bei dem Vergleich im zweiten Schritt Übereinstimmung festgestellt, ist also b(Sp)=1, so wird in einem dritten Schritt überprüft, ob der Spaltendecoder, bei dem die Übereinstimmung festgestellt wurde, zu dem Block mit dem Blockauswahlteil b der Auswahladresse oder zu einem anderen Block gehört. Diese Überprüfung ist mit b(Sp)=1 identisch abgekürzt. Im ersten Fall liegt gewöhnliche Redundanz vor, d. h. Defekte Speicherzellen des Blocks BKi werden durch Redundanzleitungen desselben Blocks BKi behoben. Die Blockauswahl erfolgt auch hier über den Blockauswahlteil b der Auswahladresse. Es wird auf die redundante Speicherzelle des ausgewählten Blocks zugegriffen. Bei Verwendung einer Spaltenredundanzleitung in diesem Block erfolgt der Zugriff mit dem Zeilenauswahlteil m und dem Redundanzspaltenadressteil n*. n* gibt die Spaltenadresse der auszuwählenden Spaltenredundanzleitung an. Erfolgt die Behebung des Defektes über die Zeilenredundanzleitung, so erfolgt der Zugriff auf die redundante Speicherzelle im Block BKi über den Spaltenauswahlteil n und den Redundanzzeilenadressteil m*. Wird sowohl eine Spaltenredundanzleitung als auch eine Zeilenredundanzleitung zur Reparatur herangezogen, so wird die redundante Speicherzelle über den Redundanzzeilenadressteil m* und den Redundanzspaltenadressteil m* angesprochen. Die angesprochene Speicherzelle wird ausgelesen oder beschrieben. Liegt bei dem Vergleich im ersten Schritt Übereinstimmung vor, ist also b(Z)=1, dann erfolgt in einem vierten Schritt eine weitere Abfrage, ob der Zeilendecoder der übereinstimmenden Adresse zu dem Block mit dem Blockauswahlteil b oder zu einem anderen Block gehört. Diese Abfrage wird mit b(Z)=1 identisch abgekürzt. Gehört der Zeilendecoder nicht zu dem Block mit dem Blockauswahlteil b, so liegt Zwischenblockredundanz in Zeilenrichtung vor. Die Blockwauswahl erfolgt über den programmierbaren Zeilendecoder, bei dem die Übereinstimmung mit der vorprogrammierten Adresse vorliegt. Der ausgewählte Block stimmt dann nicht mit dem Block mit dem Blockauswahlteil b überein. In dem ausgewählten Block wird über den Spaltenauswahlteil n und den Redundanzzeilenadressteil m* auf die redundante Speicherzelle zugegriffen. Danach erfolgt das Auslesen oder Beschreiben der Speicherzelle.

Wird im vierten Schritt festgestellt, daß der Zeilendecoder mit der übereinstimmenden vorprogrammierten Adresse zu dem Block mit dem Blockauswahlteil b gehört, so erfolgt die Abfrage wie im dritten Schritt.

Zwischenblockredundanz in Spaltenrichtung liegt dann vor, wenn b und n mit der vorprogrammierten Adresse des Spaltendecoders übereinstimmen und dieser Spaltendecoder nicht zu dem Block mit dem Blockauswahlteil b gehört. Der Zugriff auf die redundante Speicherzelle in dem Fall erfolgt über den Zeilenauswahlteil m und den Redundanzspaltenadressteil n* in dem Block, der zuvor dem Spaltendecoder zugeordnet wurde.

Das Verfahren zum Zugriff auf die redundanten Speicherzellen kann parallel oder sequentiell durchgeführt werden. Beim parallelen Verfahren wird der Blockauswahlteil b der Auswahladresse sowohl an die programmierbaren Spaltendecoder als auch an die programmierbaren Zeilendecoder zugeführt. Wird bei keinem der Decoder eine Übereinstimmung festgestellt, so liegt weder blokkeigene Redundanz noch Zwischenblockredundanz vor. Wird Übereinstimmung bei dem Spaltendecoder oder Zeilendecoder eines Blocks festgestellt, so wird dieser Block für die Zwischenblockredundanz herangezogen.

Beim sequentiellen Verfahren wird der Blockauswahlteil b zunächst nur entweder an die Spaltendecoder oder die Zeilendecoder geleitet. Im weiteren sei angenommen, daß der Vergleich von b und m nur mit den Zeilendecodern erfolgt. Wird keine Übereinstimmung festgestellt, so wird b der Auswahladresse an die Spaltendecoder geleitet. Eine endgültige Auswahl eines Blocks ist nur dann möglich, wenn auch der Spaltenauswahlteil n mit der vorprogrammierten Adresse des Spaltendecoders verglichen wird.

Wird bei dem Vergleich mit den Zeilendecodern Übereinstimmung festgestellt, so liegt Redundanz in Zeilenrichtung vor. Weiterhin kann auch Redundanz in Spaltenrichtung vorliegen. Liegt keine Redundanz in Spaltenrichtung vor, so ist der über die Redundanz in Zeilenrichtung festgelegte Block gültig. Ist die Redundanz in Zeilenrichtung eine Zwischenblockredundanz, stimmt also der aktive Block mit dem Blockauswahlteil b nicht überein und liegt zusätzlich Redundanz in Spaltenrichtung vor, so wird durch die Sperrung der übrigen, nicht aktiven Blöcke sichergestellt, daß. nicht durch die programmierbaren Spaltendecoder eine andere Blockauswahl zustande kommt, als sie durch die programmierbaren Zeilendecoder vorgegeben ist. Ist die Redundanz in Zeilenrichtung keine Zwischenblockredunanz, so kann bei Redundanz in Spaltenrichtung uber die Spaltenfusecodierung eine Redundanz in Spaltenrichtung als Zwischenblockredundanz zugelassen werden.

Zusammenfassend lassen sich folgende Bedingungen für das erfindungsgemäß.e Verfahren angeben:
1. Falls eine Zwischenblockredundanz bei einer Teilmenge der betrachteten p-Blöcke gewählt oder erforderlich ist, kann entweder nur in Spalten oder in Zeilenrichtung diese aktiviert werden. Für die restlichen Blöcke lassen sich weitere Teilmengen bilden mit anders gewählter Zwischenblockredundanz, bis alle p-Blöcke mit Zwischenblockredundanz erfaßt sind, falls dies erforderlich ist.
2. Die redundanten Leitungen innerhalb eines Blockes X, die aufgrund der Zwischenblockredundanz für einen anderen Block Y genutzt werden, können nicht mehr für den Block X genutzt werden, wohl jedoch die nicht für den Block Y genutzten.
3. Alle über b und n codierten Adressen über alle p-Blöcke müssen unterschiedlich sein, ebenso wie alle über b und m codierten Adressen, damit auf einer Adresse nur ein Speicherblock aktivierbar ist.

## Patentansprüche

1. Speicheranordnung,
mit Speicherblöcken (BK) mit jeweils über Auswahladressen auswählbaren Speicherzellen und redundanten Speicherzellen, die in Spalten und Reihen angeordnet sind,
wobei den Speicherblöcken (BK) jeweils wenigstens ein programmierbarer Spaltendecoder (PSD) und wenigstens ein programmierbarer Zeilendecoder (PZD) zur Auswahl einer der redundanten Speicherzellen in einem der Speicherblöcke (BK) zugeordnet sind, und
wobei bei wenigstens einem bestimmten Speicherblock (BK) der entsprechende programmierbare Spaltendecoder (PSD) bzw. programmierbare Zeilendecoder (PZD) derart programmiert ist, daß der bestimmte Speicherblock (BK) mit der Auswahladresse für einen anderen Speicherblock für Zugriffe auf seine redundanten Speicherzellen auswählbar ist,
**dadurch gekennzeichnet,**
**daß** der dem bestimmten Speicherblock (BK) zugeordnete programmierbare Spaltendecoder (PSD) und programmierbare Zeilendecoder (PZD) jeweils Vergleichsmittel zum Vergleich eines festgelegten Teils der Auswahladresse mit einer vorprogrammierten Adresse aufweisen, und
**daß** der dem bestimmten Speicherblock (BK) zugeordnete programmierbare Spaltendecoder (PSD) und programmierbare Zeilendecoder (PZD) derart ausgestaltet sind, daß der programmierbare Spaltendecoder (PSD) den Vergleich der Auswahladresse mit der entsprechenden vorprogrammierten Adresse nur dann durchführt, wenn der Zeilendecoder (PZD) keine Übereinstimmung zwischen der Auswahladresse und der entsprechenden vorprogrammierten Adresse festgestellt hat.

2. Speicheranordnung nach Anspruch 1,
**dadurch gekennzeichnet,**
**daß** die Vergleichsmittel des dem bestimmten Speicherblock (BK) zugeordneten programmierbaren Spaltendecoders (PSD) und Zeilendecoders (PZD) derart ausgestaltet sind, daß sie bei Übereinstimmung bei dem Vergleich der Auswahladresse mit der entsprechenden vorprogrammierten Adresse mit Ausnahme des bestimmten Speicherblocks (BK) die übrigen Speicherblöcke für Zugriffe auf Speicherzellen sperren.

3. Speicheranordnung nach Anspruch 2,
**dadurch gekennzeichnet,**
**daß** die Vergleichsmittel des dem bestimmten Speicherblock (BK) zugeordneten programmierbaren Spaltendecoders (PSD) einen zur Auswahl des Speicherblocks dienenden ersten Teil der Auswahladresse und einen zur Auswahl der Spalte dienenden zweiten Teil der Auswahladresse mit der entsprechenden vorprogrammierten Adresse vergleichen, während die Vergleichsmittel des dem bestimmten Speicherblock (BK) zugeordneten programmierbaren Zeilendecoders (PZD) den ersten Teil und einen zur Auswahl der Zeile dienenden dritten Teil der Auswahladresse mit der entsprechenden vorprogrammierten Adresse vergleichen.

4. Verfahren zum Zugriff auf redundante Speicherzellen,
wobei Speicherzellen in Spalten und Zeilen in einer Speicheranordnung mit Speicherblöcken (BK) angeordnet sind, denen jeweils wenigstens ein programmierbarer Spaltendecoder (PSD) und wenigstens ein programmierbarer Zeilendecoder (PZD) zugeordnet sind,
wobei mindestens eine bestimmte Speicherzelle eines bestimmten Speicherblocks (BK) durch eine redundante Speicherzelle eines anderen Speicherblocks ersetzt wird,
**dadurch gekennzeichnet,**
**daß** die bestimmte Speicherzelle des bestimmten Speicherblocks (BK) durch die redundante Speicherzelle des anderen Speicherblocks ersetzt wird, indem eine Auswahladresse der bestimmten Speicherzelle mit einer jeweils vorprogrammierten Adresse jedes programmierbaren Spaltendecoders (PSD) und einer jeweils vorprogrammierten Adresse jedes programmierbaren Zeilendecoders (PZD) verglichen wird, und
**daß** der Vergleich mit den vorprogrammierten Adressen der Spaltendecoder (PSD) nur erfolgt, wenn bei dem Vergleich mit den vorprogrammierten Adressen der Zeilendecoder (PZD) keine Übereinstimmung festgestellt wird.

5. Verfahren zum Zugriff auf redundante Speicherzellen nach Anspruch 4,
**dadurch gekennzeichnet,**
**daß** mit einem ersten Teil der Auswahladresse die Auswahl des Speicherblocks, mit einem zweiten Teil der Auswahladresse die Auswahl der Spalte und mit einem dritten Teil der Auswahladresse die Auswahl der Zeile der redundanten Speicherzelle vorgenommen wird, und
**daß** der erste Teil und der zweite Teil der Auswahladresse mit der entsprechenden vorprogrammierten Adresse jedes programmierbaren Spaltendecoders (PSD) und der erste Teil und der dritte Teil der Auswahladresse mit der entsprechenden vorprogrammierten Adresse jedes programmierbaren Zeilendecoders (PZD) verglichen wird.

6. Verfahren zum Zugriff auf redundante Speicherzellen nach Anspruch 5,
**dadurch gekennzeichnet,**
**daß** bei Übereinstimmung des entsprechenden Teils der Auswahladresse mit einer der vorprogrammierten Adressen der Zugriff auf die redundanten Speicherzellen desjenigen Speicherblocks freigegeben wird, bei dessen zugeordnetem Spalten- oder Zeilendecoder (PSD; PZD) die Übereinstimmung vorliegt.

7. Verfahren zum Zugriff auf redundante Speicherzellen nach Anspruch 6,
**dadurch gekennzeichnet,**
**daß** dem zweiten Teil oder dem dritten Teil oder dem zweiten Teil und dem dritten Teil der Auswahladresse zum Zugriff auf die redundante Speicherzelle eine neue Adresse zugeordnet wird.

## Claims

1. Memory arrangement
having memory blocks (BK) with memory cells which can each be selected using selection addresses and redundant memory cells which are arranged in columns and rows,
where the memory blocks (BK) each have at least one associated programmable column decoder (PSD) and at least one associated programmable row decoder (PZD) for selecting one of the redundant memory cells in one of the memory blocks (BK), and
where, for at least one particular memory block (BK), the corresponding programmable column decoder (PSD) or programmable row decoder (PZD) is programmed such that the particular memory block (BK) can be selected using the selection address for another memory block for access operations to its redundant memory cells,
**characterized**
**in that** the programmable column decoder (PSD) and programmable row decoder (PZD) associated with the particular memory block (BK) each have comparison means for comparing a stipulated part of the selection address with a preprogrammed address, and
**in that** the programmable column decoder (PSD) and programmable row decoder (PZD) associated with the particular memory block (BK) are designed such that the programmable column decoder (PSD) performs the comparison between the selection address and the corresponding preprogrammed address only if the row decoder (PZD) has not found a match between the selection address and the corresponding preprogrammed address.

2. Memory arrangement according to Claim 1,
chracterized
in that the comparison means in the programmable column decoder (PSD) and row decoder (PZD) associated with the particular memory block (BK) are designed such that, with the exception of the particular memory block (BK), they disable the rest of the memory blocks for access operations to memory cells if there is a match in the comparison between the selection address and the corresponding preprogrammed address.

3. Memory arrangement according to Claim 2,
**characterized**
**in that** the comparison means in the programmable column decoder (PSD) associated with the particular memory block (BK) compare a first part of the selection address, which first part is used for selecting the memory block, and a second part of the selection address, which second part is used for selecting the column, with the corresponding preprogrammed address, while the comparison means in the programmable row decoder (PZD) associated with the particular memory block (BK) compare the first part and a third part of the selection address, which third part is used for selecting the row, with the corresponding preprogrammed address.

4. Method for accessing redundant memory cells,
where memory cells are arranged in columns and rows in a memory arrangement containing memory blocks (BK) which each have at least one associated programmable column decoder (PSD) and at least one associated programmable row decoder (PZD),
where at least one particular memory cell in a particular memory block (BK) is replaced with a redundant memory cell in another memory block,
**characterized**
**in that** the particular memory cell in the particular memory block (BK) is replaced with the redundant memory cell in the other memory block by virtue of a selection address for the particular memory cell being compared with a respectively preprogrammed address in each programmable column decoder (PSD) and with a respectively preprogrammed address in each programmable row decoder (PZD), and
**in that** the comparison with the preprogrammed addresses in the column decoders (PSD) is performed only if no match is found in the comparison with the preprogrammed addresses in the row decoders (PZD).

5. Method for accessing redundant memory cells according to Claim 4,
**characterized**
**in that** a first part of the selection address is used to select the memory block, a second part of the selection address is used to select the column, and a third part of the selection address is used to select the row for the redundant memory cell, and
**in that** the first part and the second part of the selection address are compared with the corresponding preprogrammed address in each programmable column decoder (PSD), and the first part and the third part of the selection address are compared with the corresponding preprogrammed address in each programmable row decoder (PZD).

6. Method for accessing redundant memory cells according to Claim 5,
**characterized**
**in that**, if there is a match between the corresponding part of the selection address and one of the preprogrammed addresses, access is enabled to the redundant memory cells in that memory block in whose associated column or row decoder (PSD; PZD) the match exists.

7. Method for accessing redundant memory cells according to Claim 6,
**characterized**
**in that** the second part or the third part or the second part and the third part of the selection address is/are assigned a new address for accessing the redundant memory cell.

## Revendications

1. Dispositif mémoire,
avec des blocs de mémoire (BK) comportant chacun des cellules de mémoire et des cellules de mémoire redondantes qui peuvent être sélectionnées par l'intermédiaire d'adresses de sélection et qui sont disposées en colonnes et en lignes,
dans lequel il est associé aux blocs de mémoire (BK) à chaque fois au moins un décodeur de colonne programmable (PSD) et au moins un décodeur de ligne programmable (PZD) pour la sélection de l'une des cellules de mémoire redondantes dans l'un des blocs de mémoire (BK), et
dans lequel, pour au moins un bloc de mémoire (BK) déterminé, le décodeur de colonne programmable (PSD) correspondant ou le décodeur de ligne programmable (PZD) correspondant est programmé de telle sorte que le bloc de mémoire (BK) déterminé peut être sélectionné avec l'adresse de sélection pour un autre bloc de mémoire en vue d'accès à ses cellules de mémoire redondantes,
**caractérisé par le fait que**
le décodeur de colonne programmable (PSD) et le décodeur de ligne programmable (PZD) qui sont associés au bloc de mémoire (BK) déterminé comportent à chaque fois des moyens de comparaison pour comparer une partie fixée de l'adresse de sélection à une adresse préprogrammée, et
le décodeur de colonne programmable (PSD) et le décodeur de ligne programmable (PZD) qui sont associés au bloc de mémoire (BK) déterminé sont conçus de telle sorte que le décodeur de colonne programmable (PSD) n'effectue la comparaison entre l'adresse de sélection et l'adresse préprogrammée correspondante que si le décodeur de ligne (PZD) n'a pas trouvé de coïncidence entre l'adresse de sélection et l'adresse préprogrammée correspondante.

2. Dispositif mémoire selon la revendication 1,
**caractérisé par le fait que**
les moyens de comparaison du décodeur de colonne programmable (PSD) et du décodeur de ligne programmable (PZD) qui sont associés au bloc de mémoire (BK) déterminé sont conçus de telle sorte que, en cas de coïncidence lors de la comparaison entre l'adresse de sélection et l'adresse préprogrammée correspondante, à l'exception du bloc de mémoire (BK) déterminé, ils bloquent les autres blocs de mémoire pour des accès à des cellules de mémoire.

3. Dispositif mémoire selon la revendication 2,
**caractérisé par le fait que**
les moyens de comparaison du décodeur de colonne programmable (PSD) associé au bloc de mémoire (BK) déterminé comparent une première partie, servant à la sélection du bloc de mémoire, de l'adresse de sélection et une deuxième partie, servant à la sélection de la colonne, de l'adresse de sélection à l'adresse préprogrammée correspondante tandis que les moyens de comparaison du décodeur de ligne programmable (PZD) associé au bloc de mémoire (BK) déterminé comparent la première partie et une troisième partie, servant à la sélection de la ligne, de l'adresse de sélection à l'adresse préprogrammée correspondante.

4. Procédé pour l'accès à des cellules de mémoire redondantes,
dans lequel des cellules de mémoire sont disposées en colonnes et en lignes dans un dispositif mémoire comportant des blocs de mémoire (BK) auxquels sont associés à chaque fois au moins un décodeur de colonne programmable (PSD) et au moins un décodeur de ligne programmable (PZD),
dans lequel au moins une cellule de mémoire déterminée d'un bloc de mémoire (BK) déterminé est remplacée par une cellule de mémoire redondante d'un autre bloc de mémoire,
**caractérisé par le fait que**
la cellule de mémoire déterminée du bloc de mémoire (BK) déterminé est remplacée par la cellule de mémoire redondante de l'autre bloc de mémoire du fait qu'une adresse de sélection de la cellule de mémoire déterminée est comparée à une adresse respectivement préprogrammée de chaque décodeur de colonne programmable (PSD) et à une adresse respectivement préprogrammée de chaque décodeur de ligne programmable (PZD), et
la comparaison avec les adresses préprogrammées du décodeur de colonne (PSD) ne s'effectue que si on n'a constaté aucune coïncidence lors de la comparaison avec les adresses préprogrammées des décodeurs de ligne (PZD).

5. Procédé pour l'accès à des cellules de mémoire redondantes selon la revendication 4,
**caractérisé par le fait que**
avec une première partie de l'adresse de sélection on effectue la sélection du bloc de mémoire, avec une deuxième partie de l'adresse de sélection on effectue la sélection de la colonne et avec une troisième partie de l'adresse de sélection on effectue la sélection de la ligne de la cellule de mémoire redondante, et
on compare la première partie et la deuxième partie de l'adresse de sélection à l'adresse préprogrammée correspondante de chaque décodeur de colonne programmable (PSD) et on compare la première partie et la troisième partie de l'adresse de sélection à l'adresse préprogrammée correspondante de chaque décodeur de ligne programmable (PZD).

6. Procédé pour l'accès à des cellules de mémoire redondantes selon la revendication 5,
**caractérisé par le fait que**,
s'il y a coïncidence entre la partie correspondante de l'adresse de sélection et l'une des adresses préprogrammées, on libère l'accès aux cellules de mémoire redondantes du bloc de mémoire dont le décodeur de colonne ou de ligne associé (PSD ; PZD) donne la coïncidence.

7. Procédé pour l'accès à des cellules de mémoire redondantes selon la revendication 6,
**caractérisé par le fait que**
on associe une nouvelle adresse à la deuxième partie ou à la troisième partie ou à la deuxième partie et à la troisième partie de l'adresse de sélection en vue de l'accès à la cellule de mémoire redondante.
